# EUROPÄISCHE PATENTSCHRIFT

(11) **EP 1 046 190 B1**
(45) Veröffentlichungstag und Bekanntmachung des Hinweises auf die Patenterteilung: **19.02.2003**
(21) Anmeldenummer: 98941314.1
(22) Anmeldetag: 10.07.1998
(51) Int. Cl.: H01L 21/00

(54) **VERFAHREN UND VORRICHTUNG ZUM TROCKNEN VON SUBSTRATEN**
METHOD AND DEVICE FOR DRYING SUBSTRATES
PROCEDE ET DISPOSITIF POUR SECHER DES SUBSTRATS

(30) Priorität: 09.01.1998 DE 19800584
(43) Veröffentlichungstag der Anmeldung: 25.10.2000
(73) Patentinhaber: STEAG MicroTech GmbH, 72124 Pliezhausen (DE)
(72) Erfinder: WOLKE, Klaus, D-75382 Althengstett (DE); WEBER, Martin, D-78073 Bad Dürrheim (DE)
(74) Vertreter: Wagner, Karl H., Dipl.-Ing.
(86) Internationale Anmeldenummer: EP9804296
(87) Internationale Veröffentlichungsnummer: WO99035671

(56) Entgegenhaltungen:
- EP-A- 0 328 746
- EP-A- 0 385 536
- WO-A-97/08742
- WO-A-97/38438
- US-A- 4 960 141

## Beschreibung

Die vorliegende Erfindung bezieht sich auf ein Verfahren zum Trocknen von Substraten, gemäß dem Oberbegriff des Anspruches 1.

Ein derartiges Verfahren bzw. eine derartige Vorrichtung ist aus der DE 196 13 620 A, die auf dieselbe Patentinhaberin wie die vorliegende Anmeldung zurückgeht, bekannt.

Aus der EP-A-0 385 536 ist ein Verfahren und eine Vorrichtung zum Trocknen von Substraten nach einer Behandlung in einer Flüssigkeit bekannt. Bei dem aus dieser Druckschrift bekannten Verfahren werden Substrate für einige Zeit in einem Bad, das eine Flüssigkeit enthält, behandelt, und dann daraus entnommen, und zwar so langsam, daß praktisch die gesamte Flüssigkeit in dem Bad verbleibt. Dabei werden die Substrate von der Flüssigkeit direkt in Kontakt mit einem Dampf gebracht. Der Dampf kondensiert nicht auf den Substraten und mischt sich mit der Flüssigkeit, wobei die Mischung eine geringere Oberflächenspannung als die Flüssigkeit besitzt. Dieses Verfahren ist jedoch in der Praxis sehr aufwendig, da Dampf erforderlich ist, dieser entsorgt werden muß und insbesondere Zuführleitungen und Auslaßdüsen für den Dampf bereitgestellt werden müssen.

Aus der US-A-4 722 752 ist eine Vorrichtung und ein Verfahren zum Reinigen und Trocknen von scheibenförmigen Substraten, beispielsweise von Halbleiter-Wafern bekannt, bei der bzw. bei dem die Substrate langsam aus dem als Spülflüssigkeit dienenden heißen Wasser herausbewegt werden, wobei die oberflächenspannung am Übergang zwischen der Oberfläche des heißen Wassers und den Substraten bewirkt, daß das Wasser von den Oberflächen der Substrate abgezogen wird.

Die US-A-4 902 350 zeigt und beschreibt eine Vorrichtung und ein Verfahren zum Reinigen und Trocknen von Substraten, wobei an der Oberfläche der Flüssigkeit dem Substrat beim Ausbringen Energie in Form von Ultraschall zugeführt wird. Die zugeführte Energie dient jedoch nicht der Trocknung sondern der Reinigung.

Das aus der US-A-5 368 649 bekannte Wasch- und Trocknungsverfahren für mechanische oder elektronische Bauteile sowie Linsen verwendet zur Verbesserung des Trocknungsverfahrens eine Flüssigkeit, die unter einem über dem Atmosphärendruck liegenden Druck gehalten wird. Die Waschflüssigkeit wird über den bei Atmosphärendruck bestehenden Siedepunkt erhitzt. Für den Trockenvorgang wird das Werkstück in eine Trocknungskammer gebracht, in der eine plötzliche Dekompression stattfindet, so daß die Waschflüssigkeit auf dem Werkstück schnell verdampft.

Der Erfindung liegt die Aufgabe zugrunde, ein Verfahren anzugeben, bei dem die Substrate während des Herausfahrens aus dem Fluidbad schnell, mit geringem Aufwand, ohne Umweltbelastung und ohne Rückstände auf den Substraten getrocknet werden können.

Die erfindungsgemäße Aufgabe wird bei einem Verfahren der eingangs genannten Art durch die Merkmale des Anspruchs 1 gelöst. Dies ermöglicht eine einfache, effiziente Erhitzung des Meniskus, wobei ein heißer Gasstrom erzeugt und auf den Meniskus gerichtet wird. Die örtliche Erhitzung des Meniskus bewirkt eine Verringerung der Oberflächenspannung im gekrümmten Meniskusbereich, der sich bei Herausheben des Substrats zwischen der Substratoberfläche und der Oberfläche der Flüssigkeit ausbildet. Auf diese Weise wird die im Meniskus befindliche bzw. an der Substratoberfläche anhaftende Flüssigkeit vom Meniskus bzw. von der Substratoberfläche weg bewegt, so daß das Substrat schnell und zuverlässig im wesentlichen ohne zusätzliche Maßnahmen beim Herausheben aus der Flüssigkeit von ihr befreit und getrocknet wird. Die Verwendung von heißem Gas als Energieübertragungsmedium auf den Meniskus für dessen Erhitzung stellt ein besonders einfachesund vorteilhaftes Verfahren der Meniskuserhitzung dar.

Zur Erhitzung des Meniskus der Flüssigkeit wird vorzugsweise heißer Stickstoff verwendet, das bzw. der derart an die Flüssigkeitsoberfläche herangeführt wird, daß die Flüssigkeit im Bereich des Meniskus eine größere Temperaturerhöhung erfährt als im Flüssigkeitsbereich außerhalb des Meniskus. Das Gas wird dabei vorzugsweise über eine über die Flüssigkeit bringbare Haube eingeleitet.

Es wird darauf hingewiesen, daß unter Erhitzen ganz allgemein eine Erwärmung des Meniskus gegenüber den übrigen Bereichen der Flüssigkeit zu verstehen ist, wobei diese Temperaturunterschiede gegebenenfalls auch klein und sogar in Größenordnungen unterhalb 1° C liegen können.

Vorzugsweise wird als Heizgas ein inertes Gas verwendet, um Reaktionen oder chemische Beeinflussungen der Substrate durch das Gas zu vermeiden. Als Heizgas ist Stickstoff vorteilhaft, aber auch Edelgase sind dazu gut geeignet. Die Gase sind dabei vorzugsweise nicht mit der Flüssigkeit mischbar.

Gemäß einer sehr vorteilhaften Ausgestaltung der Erfindung wird ein Gas verwendet, das die Oberflächenspannung der Flüssigkeit, aus der die Substrate ausgebracht wird, verringert. Diese als Marangoni-Effekt bezeichnete Wirkungsweise trägt zu einer guten und schnellen Trocknung der Substrate zusätzlich bei. Vorzugsweise wird als Gas zur Verringerung der Oberflächenspannung der Flüssigkeit Stickstoff, Isopropylalkohol oder ein wenigstens diese Gase enthaltendes Gasgemisch verwendet. Das Gas zur Verringerung der Oberflächenspannung der Flüssigkeit ist dabei vorzugsweise auch als Heizgas zum Erwärmen des Meniskus verwendbar. Das Heizgas wird dem Meniskus vorteilhafterweise über eine Haube zugeführt, die über einen Flüssigkeitsbehälter, aus dem die Substrate ausgebracht werden, gebracht wird. Beispiele zur Einbringung des Gases über eine Haube sind in Zusammenhang mit der Einbringung von Gasen für die Verringerung der Oberflächenspannung der Flüssigkeit in der auf dieselbe Anmelderin zurückgehenden DE 44 13 077 A beschrieben.

Gemäß einer zusätzlichen Vorgehensweise, die nicht unter der vorliegenden Erfindung Fällt wird der Meniskus durch das mit dem Meniskus in Berührung stehende Substrat erwärmt, wobei das Substrat bzw. die Substrate vor und/oder während des Ausbringens aus der Flüssigkeit erwärmt wird bzw. werden.

In Zusammenhang mit der Erwärmung des Meniskus durch das aufgeheizte Substrat ist es besonders vorteilhaft, wenn vor und/oder gleichzeitig mit dem Erhitzen des Meniskus ein sich mit der Flüssigkeit des Meniskus mischender Dampf in Kontakt mit dem Meniskus gebracht wird. Auf diese Weise ist es möglich, die durch die Erhitzung des Meniskus eintretende Verringerung der Oberflächenspannung durch den Marangoni-Effekt zusätzlich zu verringern und dadurch die Trocknung zu verbessern und zu beschleunigen.

Bei einer Vorrichtung zum Trocknen von Substraten mit einer Energiequelle zum Erhitzen eines Meniskus, der sich beim Ausbringen der Substrate aus einer Flüssigkeit am Übergang zwischen der Substratoberfläche und der Flüssigkeitsoberfläche ausbildet, ist die Energiequelle heißes Gas, das auf den Meniskus einströmt.

Vorzugsweise wird das erfindungsgemäße Verfahren in Zusammenhang mit dem Trocknen von Halbleiter-Wafern eingesetzt, wodurch die Effizienz des Trocknungsvorgangs und dessen Zuverlässigkeit verbessert wird und die Trocknungsdauer verkürzt und damit die Produktivität des erfindungsgemäßen Verfahrens erhöht wird.

Die Erfindung wird nachstehend anhand eines bevorzugten Ausführungsbeispiels unter Bezugnahme auf die einzige, schematische Zeichnung erläutert.

Zum Trocknen eines in einer Flüssigkeit 2 befindlichen Substrats 1, das beispielsweise ein Halbleiter-Wafer sein kann, wird das Substrat 1 mit einer Substrat-Anhebe- und Absenkvorrichtung 3 aus der Flüssigkeit 2 herausgehoben. Am Übergang zwischen den Substratflächen 4 und 5 und der Flüssigkeit 2 bildet sich beim Anheben des Substrats 1 jeweils ein Meniskus 6 aus, weil die Flüssigkeit die Substratoberflächen 4, 5 benetzt und die von der Substratoberfläche auf die Flüssigkeitsmoleküle ausgeübten Adhäsionskräfte größer sind als die zwischen den Flüssigkeitsmolekülen untereinander. Im Bereich um den Meniskus 6 herum befindet sich ein Gas 7, dessen Temperatur höher ist als die Temperatur der Flüssigkeit 2. Dadurch wird der Meniskus 6 zumindest an seiner Oberfläche erwärmt, so daß die Oberflächenspannung in dem am Substrat angrenzenden, gekrümpften Meniskusbereich 6 geringer ist als in der Flüssigkeit 2 selbst. Die unterschiedlichen Oberflächenspannungen bewirken einen Fluß bzw. eine Strömung der Flüssigkeit vom Substrat 1 weg, weil die Flüssigkeitsmoleküle untereinander im Vergleich zur Anziehungskraft zwischen der Flüssigkeit und den Substratoberflächen 4, 5 eine höhere Anziehungskraft ausüben, wenn der Menikusbereich 6 mit dem ihn umgebenden Gas erhitzt wird. Auf diese Weise ist eine wesentlich bessere, vollständigere und schnellere Trocknung des Substrats 1 möglich.

Gemäß der Erfindung wird ein Strom aus heißem Gas auf den Meniskus gerichtet, um dadurch gezielt und lokal eine Aufheizung des Meniskus zu erreichen.

Die Erfindung wurde zuvor anhand einer bevorzugten Ausführungsform erläutert. Dem Fachmann sind jedoch Abwandlungen und Ausgestaltungen möglich, ohne daß dadurch der Erfindungsgedanke verlassen wird. Beispielsweise werden beim Herausbringen der Substrate aus dem Flüssigkeitsbad die Substrate direkt mit einem Dampf in Kontakt gebracht, der nicht auf dem Substrat kondensiert und der eine Substanz aufweist, die mit der Flüssigkeit mischbar ist, und, wenn sie mit der Flüssigkeit gemischt wird, eine Mischung ergibt, die eine geringere Oberflächenspannung als die Flüssigkeit besitzt. Durch die Kombination des erfindungsgemäßen Verfahrens mit dem aus der eingangs genannten EP-A-0 385 536 bekannten Verfahren ergibt sich für besondere Anwendungsfälle eine zusätzliche Verbesserung und Beschleunigung der Trocknung der Substrate. Gemäß einer vorteilhaften Ausführungsform kann als Gas 7, das zum Erhitzen des Meniskus 6 vorgesehen ist, ein Gas gewählt werden, das diese Eigenschaften zur Verringerung der Oberflächenspannung aufweist.

Vorteilhafterweise werden die Substrate durch eine messerartige Aushubvorrichtung ausgehoben. Die messerartige Aushubvorrichtung trägt die Substrate, wenn sie aus der Flüssigkeit herausgehoben werden, und zwar an denjenigen Stellen der Substrate, die als letztes die Flüssigkeit verlassen. Tropfen der Flüssigkeit strömen dann über die messerartige Kante der messerartigen Aushubvorrichtung von dem Substrat ab, so daß auch beim Austritt des Substrats aus dem Flüssigkeitsbad, wenn ein Meniskus nicht mehr definiert ist, das Trocknungsverfahren mit gleicher Effizienz fortgesetzt werden kann.

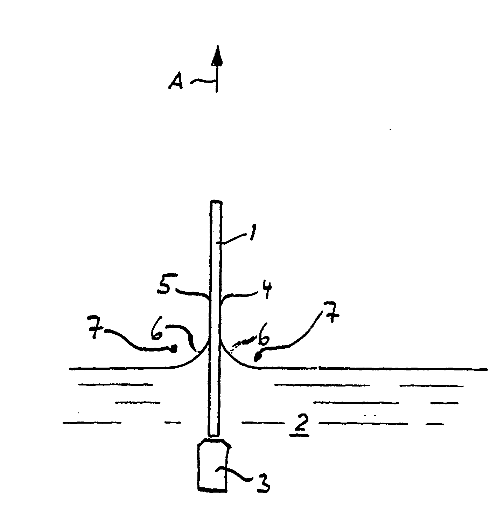

## Patentansprüche

1. Verfahren zum Trocknen von Substraten (1), bei deren Ausbringen aus einer Flüssigkeit (2) ein sich am Übergang zwischen der Substratoberfläche (4, 5) und der Flüssigkeit (2) ausbildender Meniskus (6) der Flüssigkeit (2) auf eine höhere Temperatur als im Flüssigkeitsbereich außerhalb des Meniskus erhitzt wird, **dadurch gekennzeichnet, daß** der Meniskus durch einen auf den Meniskus (6) gerichteten heißen Gasstrom erhitzt wird.

2. Verfahren nach Anspruch 1, **dadurch gekennzeichnet, daß** der Gasstrom ein inertes Gas ist.

3. Verfahren nach einem der vorhergehenden Ansprüche, **dadurch gekennzeichnet, daß** der Gasstrom wenigstens Stickstoff und/oder ein Edelgas umfaßt.

4. Verfahren nach einem der vorhergehenden Ansprüche, **dadurch gekennzeichnet, daß** der Gasstrom nicht mit der Flüssigkeit mischbar ist.

5. Verfahren nach Anspruch 1, **dadurch gekennzeichnet, daß** der Gasstrom die Oberflächenspannung der Flüssigkeit (2), aus der die Substrate (1) ausgebracht werden, verringert.

6. Verfahren nach einem der vorhergehenden Ansprüche, **dadurch gekennzeichnet, daß** vor und/oder gleichzeitig mit dem Erhitzen des Meniskus (5) ein sich mit der Flüssigkeit (2) des Meniskus (5) mischender Dampf in Kontakt mit dem Meniskus (5) gebracht wird.

7. Verfahren nach Anspruch 5 oder 6, **dadurch gekennzeichnet, daß** das Gas oder der Dampf Stickstoff, Isopropylalkohol oder ein wenigstens eines dieser Gase enthaltendes Dampfgemisch ist.

8. Verfahren nach einem der vorhergehenden Ansprüche, **dadurch gekennzeichnet, daß** das Gas dem Meniskus (6) über eine Haube zugeführt wird, die über einen Flüssigkeitsbehälter, aus dem die Substrate (1) ausgebracht werden, gebracht wird.

## Claims

1. Method of drying substrates (1), during the removal of which from a liquid (2) a meniscus (6), which forms at the transition between the substrate surface (4, 5) and the liquid (2), of the liquid (2) is heated to a higher temperature than in the liquid region outside the meniscus, **characterised in that** the meniscus is heated by a hot gas flow directed onto the meniscus (6).

2. Method according to claim 1, **characterised in that** the gas flow is an inert gas.

3. Method according to one of the preceding claims, **characterised in that** the gas flow comprises at least nitrogen and/or a rare gas.

4. Method according to one of the preceding claims, **characterised in that** the gas flow is not miscible with the liquid.

5. Method according to claim 1, **characterised in that** the gas flow reduces the surface tension of the liquid (2) from which the substrates (1) are extracted.

6. Method according to one of the preceding claims, **characterised in that** before and/or simultaneously with the heating of the meniscus (5) a vapour miscible with the liquid (2) of the meniscus (5) is brought into contact with the meniscus (5).

7. Method according to claim 5 or 6, **characterised in that** the gas or the vapour is nitrogen, isopropylalcohol or a vapour mixture containing at least one of these gases.

8. Method according to one of the preceding claims, **characterised in that** the gas is fed to the meniscus (6) by way of a hood which is brought over a liquid container from which the substrates (1) are extracted.

## Revendications

1. Procédé de séchage de substrats (1) lors de la sortie desquels d'un liquide (2), un ménisque (6) du liquide (2) se formant à l'emplacement de transition entre la surface de substrats (4, 5) et le liquide (2) est chauffé à une température plus élevée que dans la zone de liquide à l'extérieur du ménisque, **caractérisé en ce que** le ménisque est chauffé par un flux de gaz chaud dirigé sur le ménisque (6).

2. Procédé selon la revendication 1, **caractérisé en ce que** le flux de gaz est un gaz inerte.

3. Procédé selon l'une des revendications précédentes, **caractérisé en ce que** le flux de gaz comprend au moins de l'azote et/ou un gaz rare.

4. Procédé selon l'une des revendications précédentes, **caractérisé en ce que** le flux de gaz ne peut pas être mélangé avec le liquide.

5. Procédé selon la revendication 1, **caractérisé en ce que** le flux de gaz réduit la tension de surface du liquide (2) duquel les substrats (1) sont sortis.

6. Procédé selon l'une des revendications précédentes, **caractérisé en ce qu'**avant et/ou simultanément avec l'échauffement du ménisque (5), une vapeur se mélangeant avec le liquide (2) du ménisque (5) est amenée en contact avec le ménisque (5).

7. Procédé selon la revendication 5 ou 6, **caractérisé en ce que** le gaz ou la vapeur est de l'azote, de l'alcool isopropylique ou un mélange de vapeurs contenant au moins l'un de ces gaz.

8. Procédé selon l'une des revendications précédentes, **caractérisé en ce que** le gaz est amené au ménisque (6) par un capot qui est amené au-dessus d'un récipient de liquide duquel les substrats (1) sont sortis.
